Europäisches Patentamt

European Patent Office

Office européen des brevets

(11) Publication number: **0 508 661 A1**

## EUROPEAN PATENT APPLICATION

(21) Application number: **92302805.4**

(22) Date of filing: **30.03.92**

(51) Int. Cl.⁵: **H03C 3/09**

(30) Priority: **11.04.91 US 683982**

(43) Date of publication of application:
**14.10.92 Bulletin 92/42**

(84) Designated Contracting States:
**DE FR IT**

(71) Applicant: **HARRIS CORPORATION**
**1025 West NASA Blvd**
**Melbourne, FL 32919(US)**
Applicant: **PROXIM, INC.**
**295 North Bernardo Avenue**
**Mountain View, CA 94043(US)**

(72) Inventor: **Twitchell, Edwin R**
**1606 Payson,**
**Ouincy, Illinois 62301(US)**
Inventor: **McCune, Earl W Jr**
**2252 Sutter Avenue**
**Santa Clara, California 95050(US)**

(74) Representative: **Walters, Frederick James**
**Urquhart-Dykes & Lord 91 Wimpole Street**
**London W1M 8AH(GB)**

(54) **An FM modulator circuit having separate modulation and channel signal paths.**

(57) An FM modulator circuit is provided having separate modulation (100) and channel signal paths (102). The modulation path includes a numerically controlled modulated oscillator (104) which receives a modulation signal and provides a modulated intermediate frequency signal which has been frequency modulated in accordance with the modulation signal. A channel select number is provided representative of a channel of a desired frequency. A channel signal path is provided including local oscillator means for receiving the channel select signal and providing a channel signal of the desired frequency. The modulated intermediate frequency is then combined with the channel signal to provide the desired FM output signal.

**Fig.2** Prior Art

## Field of the Invention

This invention relates to the art of frequency modulation and, more particularly, to a circuit which provides up conversion of a digitally generated frequency modulated signal employing separate modulation and channel signal paths.

## Background of the Invention

It is sometimes desirable to have an FM signal generator, sometimes referred to as an FM exciter, available as a standby which can be quickly substituted for a signal generator taken out of service and in which the standby signal generator can be quickly tuned to a desired center frequency, such as within the frequency band of from 87.5 MHz to 108 MHz. In the United States, the Federal Communications Commission (FCC) has required that the operation of such FM signal generators be such that the frequency deviation from the center frequency be limited to within ±0.075 MHz. It is frequently desirable by broadcasters to operate with a frequency deviation approaching as close as possible to the deviation limitation of ±0.075 MHz in order to achieve maximum "loudness".

A problem in attempting to achieve the above objectives is that present day FM signal generators frequently employ a voltage controlled oscillator (VCO) in the modulation path. The VCO is set to a desired center frequency within the FM band of 87.5 to 108 MHz. The input to the VCO is varied by a modulation signal, such as an audio signal. Typically, the VCO has a nonlinear frequency deviation response characteristic such that when the signal generator is tuned to a particular center frequency, various signal correction circuits must be adjusted to compensate for the nonlinear frequency deviation response characteristics. This adjustment process is frequently time consuming.

At present, an FM signal may be generated by digital means such as by a numeric controlled modulated oscillator (NCMO), such as that described in the U.S. Patent to E. W. McCune, 4,746,880. Unlike the VCO, such NCMO devices have linear frequency deviation response characteristics. By employing an NCMO one can quickly change an input number to obtain a different center frequency of operation and obtain a frequency deviation accurately approaching ±0.075 MHz around the center frequency without the need for time-consuming efforts of adjusting corrections circuits, as in the case of adjusting a VCO as discussed above.

However, such NCMO circuits typically employ digital devices including adders and look-up tables. Such a look-up table may take the form of a programmable read only memory (PROM). The operation of such digital devices is limited to clock rates well below the primary radio frequency FM band of 87.5 to 108 MHz. For example, to obtain good resolution, such devices typically operate at a lower frequency level, such as on the order of 20 MHz and require an up conversion to a higher frequency if they are to be employed in providing an FM signal in the frequency band of 87.5 to 108 MHz.

The U.S. Patent to L. J. Avila et al., 4,706,047 discloses a system employing digital means for generating an FM signal at a relatively low frequency together with a phase lock loop (PLL) and which includes a VCO to place the output signal at a higher frequency. However, Avila's PLL circuit employs a VCO in the modulation path. Consequently, the VCO employed has a nonlinear frequency deviation response characteristic as discussed hereinabove. This limits the use of such a circuit to an FM signal generator having a fixed center frequency as one cannot quickly retune the signal generator to a different center frequency because time-consuming adjustments are required of correction circuits to correct for the nonlinear frequency deviation response characteristics of the VCO.

## Summary of the Invention

It is, therefore, a primary object of the present invention to provide an FM modulator circuit having separate modulation and channel signal paths so that each path can be individually and independently optimized.

In accordance with the present invention, the FM modulator circuit includes a modulation path having a numerically controlled oscillator which receives a modulation signal and provides a frequency modulated intermediate frequency signal which has been frequency modulated in accordance with the modulation signal. A channel select number is provided representative of a channel of a desired frequency. A channel signal path is provided including local oscillator means for receiving the channel select signal and providing a channel signal of the desired frequency. The modulated intermediate frequency signal is then mixed with the channel signal to provide a frequency up-converted FM output signal.

## Brief Description of the Drawings

The foregoing and other objects of the invention will become more readily apparent from the following description of the preferred embodiment of the invention as taken in conjunction with the accompanying drawings which are a part hereof and wherein:

Fig. 1 is a schematic-block diagram illustration of a prior art FM signal generator;

Fig. 2 is a graphical illustration of control signal amplitude with respect to frequency useful in describing the operation of the VCO illustrated in Fig. 1;

Fig. 3 is a schematic-block diagram illustration of a preferred embodiment of the invention herein; and

Fig. 4 is a schematic-block diagram illustration of a numeric controlled modulated oscillator (NCMO) employed in the circuit of Fig. 3.

## Description of Preferred Embodiment

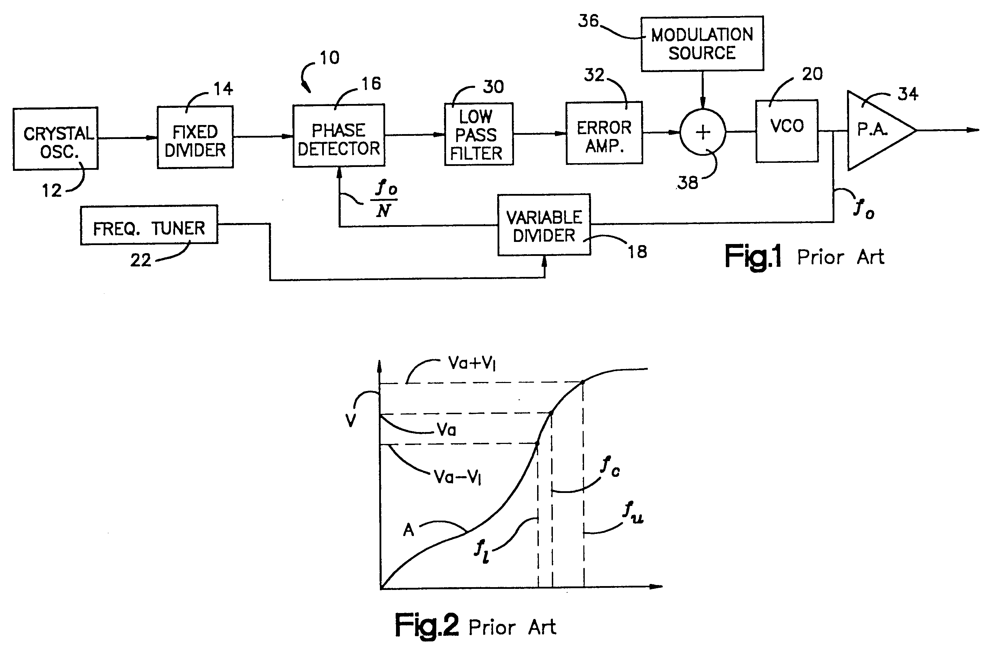

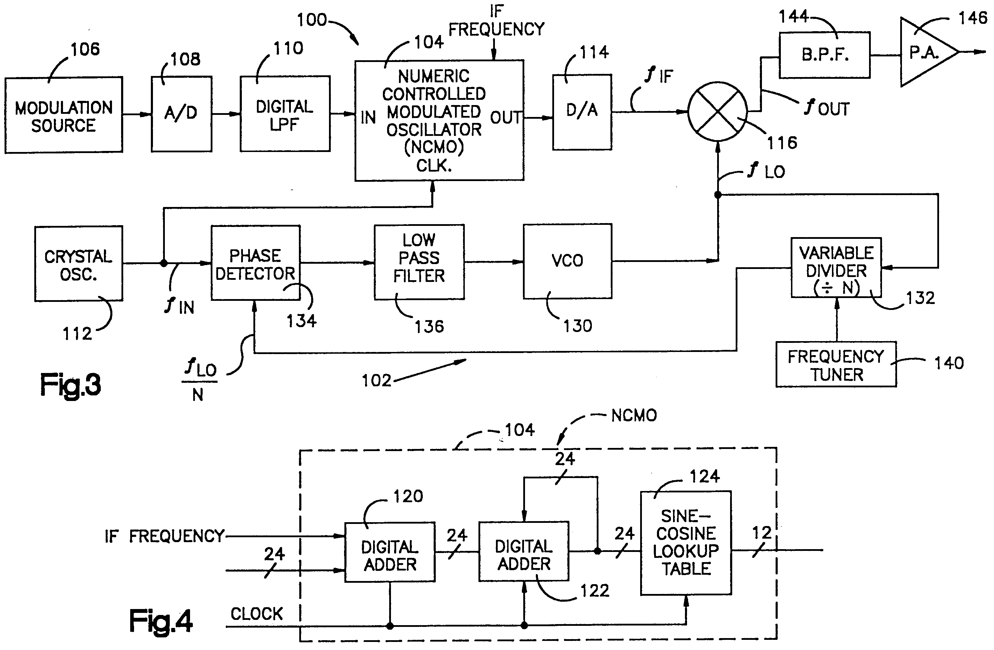

Before describing the preferred embodiment in conjunction with Figs. 3 and 4, reference is first made to Figs. 1 and 2 which disclose a prior art FM signal generator and a graphical illustration of control signal amplitude with respect to frequency showing the manner in which the VCO in Fig. 1 operates.

The prior art FM signal generator 10 in Fig. 1 includes a crystal oscillator 12 which may provide a very accurate reference frequency and which may be on the order of 10 MHz which is then applied to a fixed divider 14 with the output being applied to one input of a phase detector 16. This phase detector is part of a phase lock loop (PLL) to be described hereinafter. The other input to the phase detector 16 is obtained from a variable divider 18 which divides the output frequency of a voltage controlled oscillator (VCO) 20 by a variable number N. The value of N is adjusted by means of a frequency tuner 22. The output of the phase detector is then supplied through a low-pass filter 30 and is amplified by an error amplifier 32 which then provides a DC voltage, representative of the required VSO control signal amplitude, to the input of the VCO 20. The FM signal obtained from the VCO is fed back to the variable divider in the phase lock loop (PLL) and is also supplied to a power amplifier 34. The output frequency of the VCO may be considered frequency $F_0$ and it varies from a center frequency $F_c$ in accordance with a modulation signal provided to the VCO by means of a modulation source 36. The modulation signal is supplied to a summing point 38 that is actually inside the VCO 20. When the FM signal generator 10 is adjusted to transmit a particular center frequency $F_c$, the frequency tuner 22 is operated to adjust the value of N so that the phase lock loop drives the VCO to operate at the desired center frequency $F_c$. However, the VCO exhibits nonlinear frequency deviation response characteristics, as will be noted from reference to Fig. 2.

In Fig. 2 curve A represents the frequency control response characteristics of a voltage controlled oscillator, such as VCO 20. It is to be noted that curve A is a nonlinear curve. For example, if an operator is tuning the transmitter to a center frequency $F_c$ of a particular frequency value, then this may correspond with an input voltage being supplied to the VCO of a magnitude of $V_A$. The FCC has required that broadcasters limit the modulation operation so that the frequency deviation from the center line frequency will not exceed ±0.075 MHz. Thus, the lower frequency $F_L$ should not deviate from the center frequency $F_c$ by more than 0.075 MHz and the upper frequency $F_U$ should not exceed the center frequency $F_c$ by more than 0.075 MHz. However, by inspecting the nonlinear curve of Fig. 2, it is seen that varying the voltage $V_A$ by ±$V_1$ results in lower and upper frequencies $F_L$ and $F_U$ which represent substantially different frequency deviations from the center frequency $F_c$. Thus, if the lower frequency $F_L$ deviates from that of the center frequency $F_c$ on the order of 0.075 MHz, then the upper frequency $F_U$ has exceeded the maximum frequency deviation permitted by the FCC. It is for this reason that the signal generator of Fig. 1 requires signal correction circuitry (not shown) that must be adjusted when tuning the signal generator to correct for the nonlinear response characteristics. Such adjustments may be made at the factory at which the signal generator is manufactured so that it is adjusted for a particular center frequency. However, to change the frequency in the field from a particular center frequency, such as 102 MHz, to a different center frequency, such as a 104 MHz, requires considerable time and effort in adjusting signal correction circuitry.

Reference is now made to Fig. 3 which illustrates an FM signal generator constructed in accordance with the present invention and in which the center frequency may be easily changed in the field. Moreover, the circuit of Fig. 3 separates the modulation signal path from the channel signal path. As shown in Fig. 3, there is provided a modulation path 100 and a channel signal path 102. In this circuit, the modulation signal path 100 does not include a VCO, as in the case of the prior art discussed hereinbefore. Instead, the modulation path 100 includes a numeric controlled modulated oscillator (NCMO) 104 which includes digital means for generating a frequency modulated signal. Suitable NCMO's are available on the market and, for example, the NCMO 104 may be obtained from Digital RF Solutions Corporation of Santa Clara, California, and which device is described in the U.S. Patent to E. W. McCune, Jr., 4,746,880. The modulation input to the NCMO 104 is usually digitized from an analog modulation source 106, which may include an audio signal. The audio signal from the modulation source 106 is converted by an analog-to-digital converter 108 into a multi-bit digital word, such as 24 bits, which is then passed through a digital correction filter 110 to remove non-ideal characteristics from the digitized signal, supplying a digitized 24 bit modulation signal to the input of the NCMO 104. A crystal oscillator 112 provides a clock signal and which may have a frequency on the order of 10 MHz and this is supplied to the clock input of the NCMO which then digitally generates a multi-bit (12 bit) frequency modulated signal and which is then converted to an analog signal by a digital-to-analog converter 114 and supplied to one input of a mixer 116. The NCMO 104 has an input for receiving a control number representing the desired IF frequency.

The numeric controlled oscillator NCMO 104 preferably takes the form as described in the McCune patent discussed hereinabove. A simplified showing of such an NCMO 104 is illustrated in Fig. 4, from which it is seen that the multi-bit digitized modulation signal is supplied to a digital adder 120, the output of which is supplied to a second digital adder operating as a phase accumulator and which provides a 24 bit address to a look-up table 124 and which may take the form of a programmable read only memory (PROM). The adders and the look-up table are all clocked by the clock signal obtained from the crystal oscillator 112 (Fig. 3). Consequently, it is seen that the operation of the NCMO is limited in its frequency to the maximum clock rate at which the digital components may operate including the time required to read values from the look-up table 124 to provide a 12 bit digital output. This is considerably below the radio frequency modulation band of 87.5 MHz to 108 MHz. Thus, the NCMO may operate at a relatively low center frequency $F_c$ such as on the order of 3 MHz. Since the frequency deviation response characteristics are linear, the modulation may be set for the maximum allowed level, which for the United States is ±0.075 MHz relative to the center frequency $F_c$. The output frequency of the digital-to-analog converter 114 may be considered as an intermediate frequency $F_{IF}$. This needs to be raised to a higher frequency in the radio frequency band of 87.5 MHz to 108 MHz. This is achieved with the circuitry to be described below.

The up-conversion circuitry of Fig. 3 includes a separate channel signal path 102 and which includes a local oscillator which produces a channel frequency signal $F_{LO}$ which, when combined with the output frequency signal $F_{IF}$, provides a center frequency of the desired operating frequency for the broadcast station. For example, if it is intended that the broadcast station have a center frequency of 102 MHz and if the center frequency of the intermediate frequency signal $F_{IF}$ is on the order of 3 MHz, then it is clear that the channel frequency signal $F_{LO}$ must be adjusted to exactly 99.0 MHz, or its equivalent using multiple conversions according to general and common practice. This is achieved with the described signal conversion circuitry discussed below.

The channel select path includes a VCO 130 located in the phase lock loop (PLL) and which includes a variable divider 132, a phase detector 134 and a low-pass filter 136 all connected as illustrated in Fig. 3. The operator will adjust a frequency tuner 140, such as a conventional thumb wheel switch, to vary the value of N so as to divide the output frequency $F_{LO}$ obtained from the voltage controlled oscillator by the number N. The phase detector compares the output signal $F_{IN}$ of the crystal oscillator with the output of the variable divider, which is $F_{LO}$ divided by N, and adjusts the operation of the VCO until the two signals match. The local oscillator signal $F_{LO}$ is then supplied to the mixer 116 where it is mixed with the intermediate frequency signal $F_{IF}$ to obtain an output frequency signal $F_{OUT}$ which is then passed through a bandpass filter 144 which passes the frequencies in a select band within the FM bandwidth of 87.5 MHz to 108 MHz with the output signal then being supplied to a suitable power amplifier 146.

By separating the modulation path from the carrier or channel signal path, both the modulation path 100 and the channel signal path 102 may be individually and independently optimized. This permits direct application of numeric modulation to achieve the full signal modulation specification. The modulation path is optimized for linearity and allows for use of an accurate numeric controlled oscillator which has a linear frequency deviation response characteristic. Still further, by separating the two paths, the VCO is set to operate at only one specific frequency, as no frequency deviations or modulations are involved in the operation of the VCO. The bandwidth of the phase lock loop may be set to optimize for output noise. Also, by providing the separate channel signal path, fast lock up times may be achieved with significantly reduced microphonics.

Although the invention has been described in conjunction with a preferred embodiment, it is to be appreciated that various modifications may be made without departing from the spirit and scope of the invention as defined by the appended claims.

**Claims**

1. An FM modulator circuit having separate modulation and channel signal paths, comprising:
   means for providing a modulating signal;
   a modulation path including numerically controlled oscillator means having means for receiving said modulating signal and for providing a frequency modulated intermediate frequency signal which has been frequency modulated in accordance with said modulating signal;

means for providing a channel select signal representative of a channel signal of a desired frequency;

a channel signal path including local oscillator means for receiving said channel select signal and providing a said channel signal of said desired frequency; and

mixer means for mixing said modulated intermediate frequency signal with said channel signal to provide a frequency converted FM output signal.

2. A circuit as set forth in claim 1 wherein said local oscillator means includes a phase lock loop (PLL).

3. A circuit as set forth in claim 2 wherein said phase lock loop includes a voltage controlled oscillator (VCO) for providing a said channel signal, a variable divider means for adjusting the frequency of the channel signal, and phase detector means for comparing the frequency of the channel signal as adjusted by the variable divider with a reference frequency signal for purposes of driving the VCO so as to operate to provide a channel signal of said desired frequency.

4. A circuit as set forth in claim 3 including a low-pass filter in said channel signal path and located intermediate said phase detector means and said VCO.

5. A circuit as set forth in claim 4 including a crystal oscillator for providing said reference frequency signal.

6. A circuit as set forth in claim 5 wherein said variable divider means includes means for dividing the frequency of said channel signal by a number N, and frequency tuner means coupled to said variable divider means for varying the value of the number N so as to change the frequency of said channel signal from one frequency to another.

7. A circuit as set forth in claim 1 wherein said numerically controlled oscillator means includes numerically controlled modulated oscillator means having a multi-bit input for receiving a multi-bit digital modulating signal for digitally generating said frequency modulated intermediate frequency signal having a frequency deviation from a center frequency in dependence upon the value of said digitized modulating signal.

8. A circuit as set forth in claim 7 wherein said means for providing a modulating signal includes an analog modulating source and analog-to-digital converter means for providing said modulating signal as said multi-bit digital modulating signal for application to said multi-bit input of said numerically controlled modulated oscillator means.

9. A circuit as set forth in claim 8 including digital filter means interposed between said analog-to-digital means and said numerically controlled modulated oscillator means for removing such non-ideal characteristics of the multi-bit digital modulating signals as may be imposed by the analog-to-digital means in generating such multi-bit digital modulating signal.

10. A circuit as set forth in claim 9 wherein said frequency modulated intermediate frequency signal provided by said numerically controlled modulated oscillator means is a multi-bit digital frequency modulated signal and wherein said circuit includes digital-to-analog converter means for converting said multi-bit digital frequency modulated signal into an analog frequency modulated intermediate frequency signal prior to application to said mixer means to provide an analog frequency up-converted FM output signal.

11. A circuit as set forth in claim 10 wherein said local oscillator means includes a phase lock loop (PLL).

12. A circuit as set forth in claim 11 wherein said PLL includes a voltage controlled oscillator (VCO) for providing a said channel signal, a variable divider means for adjusting the frequency of the channel signal, phase detector means for comparing the frequency of the channel signal as adjusted by the variable divider with a reference frequency signal for purposes of driving the VCO so as to operate to provide a channel signal of said desired frequency.

13. A circuit as set forth in claim 12 including a low-pass filter in said channel signal path and located intermediate said phase detector means and said VCO.

**Fig.1** Prior Art

**Fig.2** Prior Art

EP 0 508 661 A1

Fig.3

Fig.4

EP 0 508 661 A1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | EP-A-0 036 431 (TOYO COMMUNICATION EQUIPMENT)<br>* page 2, line 5 - line 12 *<br>* page 5, line 4 - line 5 *<br>* page 5, line 13 - line 22 *<br>* page 8, line 18 - line 25 *<br>* page 9, line 13 - line 20; figures 1,2 *<br>--- | 1-7 | H03C3/09 |
| Y,D | US-A-4 746 880 (E. W. MCCUNE)<br>* column 4, line 20 - line 34 *<br>* column 8, line 1 - line 8; figure 1 *<br>--- | 1-7 | |
| X,P | US-A-5 010 585 (R. A. GARCIA)<br>* column 2, line 25 - line 52 *<br>* claims 1,4,9; figure 1 *<br>--- | 1,2 | |
| A,D | US-A-4 706 047 (L. J. AVILA ET. AL.)<br>* column 2, line 47 - column 3, line 25; claim 1; figure 1 *<br>----- | 1-7 | |
| | | | **TECHNICAL FIELDS SEARCHED (Int. Cl.5)**<br><br>H03C |

The present search report has been drawn up for all claims

| Place of search | Date of completion of the search | Examiner |
|---|---|---|
| THE HAGUE | 19 JUNE 1992 | BUTLER N.A. |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P0401)